# EUROPEAN PATENT SPECIFICATION

(11) **EP 4 439 789 B1**
(45) Date of publication and mention of the grant of the patent: **21.01.2026**
(21) Application number: 24166355.8
(22) Date of filing: 26.03.2024
(51) Int. Cl.: H01M 10/48, H02J 7/00, G01R 31/52, G01R 31/327, H01M 10/42, H01M 50/574

(54) **BATTERY PACK AND METHOD OF OPERATING THE SAME**
BATTERIEPACK UND VERFAHREN ZUM BETRIEB DAVON
BLOC-BATTERIE ET SON PROCÉDÉ DE FONCTIONNEMENT

(30) Priority: 27.03.2023 KR 20230040013; 20.06.2023 KR 20230078920
(43) Date of publication of application: 02.10.2024
(73) Proprietor: Samsung SDI Co., Ltd., Yongin-si, Gyeonggi-do 17084 (KR)
(72) Inventor: PARK, Seonghun, 17084 Yongin-si (KR)
(74) Representative: Marks & Clerk LLP

(56) References cited:
- US-A1- 2019 064 280
- US-A1- 2021 231 707
- US-A1- 2022 260 637
- US-A1- 2022 404 418

## Description

### BACKGROUND

### 1. Field

One or more embodiments relate to a battery pack and a method of operating the same.

### 2. Description of the Related Art

Secondary cells with electrical characteristics, such as high energy density, may be variously used in battery systems, electric vehicles (EVs), or hybrid electric vehicles (HEVs) in the form of a battery pack. On the assumption that the same output is supplied, a high voltage may lead to a reduction in the current amount, and thin and lightweight lines may be used. There is an increasing trend in using battery packs outputting high voltage. Battery management systems are also known. See, for example, US2019/0064280.

A battery pack outputting a high voltage employs a relay switch to control charging and discharging. The relay switch may be welded because of a high voltage, and the battery pack may be configured to check whether the relay switch is welded. However, a voltage of a link capacitor between pack terminals is attributed to misdiagnosing the welding of the relay switch even though the relay switch is not welded.

### SUMMARY

One or more embodiments include a battery pack capable of accurately determining whether a high-voltage relay switch malfunctions, e.g. is welded, and a method of accurately diagnosing whether a high-voltage relay switch malfunctions, e.g. is welded.

One or more embodiments include a welding diagnosis method capable of improving the reliability of determining the welding diagnosis of a high-voltage relay switch.

Additional aspects will be set forth in part in the description which follows and, in part, will be apparent from the description, or may be learned by practice of the presented embodiments of the present disclosure.

According to one or more embodiments, a battery pack includes a first pack terminal, a second pack terminal, a battery including battery cells (i.e. a plurality of battery cells) between a first battery terminal and a second battery terminal, a first main switch between the first pack terminal and the first battery terminal, a first resistor and a first insulated switch connected in series between the first battery terminal and a ground, a second resistor and a second insulated switch connected in series between the second battery terminal and the ground, and a controller configured to control the first insulated switch and the second insulated switch to alternately repeat a first state, in which the first insulated switch is closed and the second insulated switch is opened, and a second state, in which the first insulated switch is opened and the second insulated switch is closed, detect a first terminal voltage between the first pack terminal and the ground. The controller is further configured to open the first main switch, and determine whether the first main switch malfunctions, e.g. is welded, based on a difference between the first terminal voltage in the first state and the first terminal voltage in the second state.

The controller may be further configured to determine that the first main switch malfunctions (e.g. is welded) based on an absolute value of a variation in the first terminal voltage from the first state to the second state being greater than a threshold value - i.e. a preset threshold value.

The controller may be further configured to determine that the first main switch malfunctions (e.g. is welded) based on an absolute value of a variation in the first terminal voltage from the second state to the first state being greater than the threshold value.

The battery pack may further include a second main switch between the second pack terminal and the second battery terminal. The controller may be further configured to detect a second terminal voltage between the second pack terminal and the ground, and open the second main switch, and determine whether the second main switch malfunctions (e.g. is welded) based on a difference between the second terminal voltage in the first state and the second terminal voltage in the second state.

The controller may be further configured to open the first main switch and the second main switch, and determine that the first main switch malfunctions (e.g. is welded) based on an absolute value of a variation in the first terminal voltage being greater than a threshold value - i.e. a preset threshold value, and/or determine that the second main switch malfunctions (e.g. is welded) based on an absolute value of a variation in the second terminal voltage being greater than the threshold value, during a transition from the first state to the second state, or from the second state to the first state.

The controller may be further configured to detect a first battery voltage between the first battery terminal and the ground, close the first main switch, and determine whether the first main switch malfunctions (e.g. is welded) based on a difference between a variation in the first battery voltage and a variation in the first terminal voltage during a transition from the first state to the second state, or from the second state to the first state.

The controller may be further configured to detect a second battery voltage between the second battery terminal and the ground, detect a second terminal voltage between the second pack terminal and the ground, close the second main switch, and determine whether the second main switch malfunctions based on a difference between a variation in the second battery voltage and a variation in the second terminal voltage during a transition from the first state to the second state, or from the second state to the first state.

According to one or more embodiments, there is a method of operating a battery pack. The battery pack includes a battery, a first main switch between a first pack terminal and a first battery terminal, a second main switch between a second pack terminal and a second battery terminal, a first resistor and a first insulated switch connected in series between the first battery terminal and a ground, and a second resistor and a second insulated switch connected in series between the second battery terminal and the ground. The method includes opening the first main switch, controlling the first insulated switch and the second insulated switch to alternately repeat a first state, in which the first insulated switch is closed and the second insulated switch is opened, and a second state, in which the first insulated switch is opened and the second insulated switch is closed, detecting a first terminal voltage between the first pack terminal and the ground, and determining whether the first main switch malfunctions (e.g. is welded) based on a difference between the first terminal voltage in the first state and the first terminal voltage in the second state.

The method may further include opening the second main switch, detecting a second terminal voltage between the second pack terminal and the ground, and determining whether the second main switch malfunctions(e.g. is welded) based on a difference between the second terminal voltage in the first state and the second terminal voltage in the second state.

The method may further include closing the first main switch, controlling the first insulated switch and the second insulated switch to alternately repeat the first state, in which the first insulated switch is closed and the second insulated switch is opened, and the second state, in which the first insulated switch is opened and the second insulated switch is closed, detecting a first battery voltage between the first battery terminal and the ground, detecting the first terminal voltage between the first pack terminal and the ground, and determining whether the first main switch malfunctions based on a difference between a variation in the first battery voltage and a variation in the first terminal voltage between the first state and the second state.

The method may further include closing the second main switch, detecting a second battery voltage between the second battery terminal and the ground, detecting a second terminal voltage between the second pack terminal and the ground, and determining whether the second main switch malfunctions based on a difference between a variation in the second battery voltage and a variation in the second terminal voltage between the first state and the second state.

The invention is defined by the features of the independent claims. Optional features are defined in the dependent claims.

### BRIEF DESCRIPTION OF THE DRAWINGS

The above and other aspects of embodiments of the present disclosure will be more apparent from the following description taken in conjunction with the accompanying drawings, in which:
FIG. 1 shows a battery pack according to embodiments of the present disclosure;
FIG. 2 is a flowchart for explaining a method of diagnosing whether a main switch of a battery pack is welded, according to embodiments of the present disclosure;
FIG. 3 shows an example of first and second battery voltages and first and second terminal voltages based on states of first and second insulated switches of a battery pack with open first and second main switches, according to embodiments of the present disclosure;
FIG. 4 shows an example of first and second battery voltages and first and second terminal voltages based on states of first and second insulated switches of a battery pack with a welded first main switch, according to embodiments of the present disclosure;
FIG. 5 shows an example of first and second battery voltages and first and second terminal voltages based on states of first and second insulated switches of a battery pack with a welded second main switch, according to embodiments of the present disclosure; and
FIG. 6 shows an example of first and second battery voltages and first and second terminal voltages based on states of first and second insulated switches of a battery pack with closed first and second main switches, according to embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

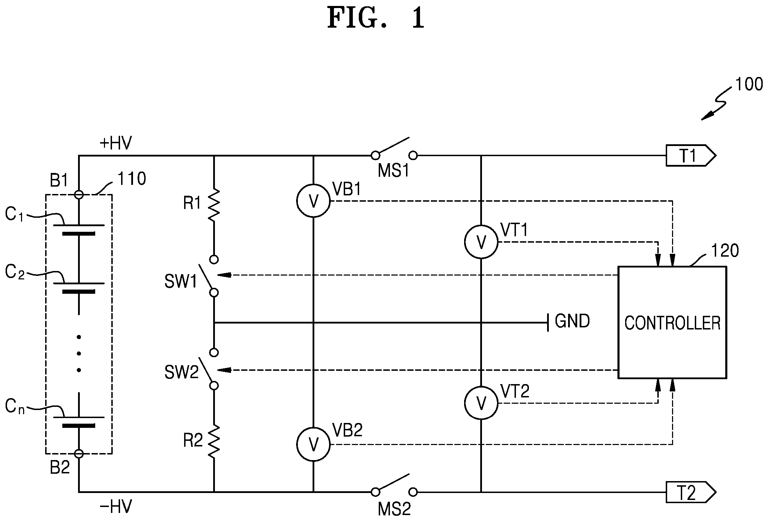

FIG. 1 shows a battery pack according to embodiments of the present disclosure.

Referring to FIG. 1, a battery pack 100 includes first and second pack terminals T1 and T2, a battery 110 including a plurality of battery cells C₁ to Cₙ between first and second battery terminals B1 and B2, a first main switch MS1 connected between the first battery terminal B1 and the first pack terminal T1, and a second main switch MS2 connected between the second battery terminal B2 and the second pack terminal T2.

The battery pack 100 may include a first resistor R1 and a first insulated switch SW1 connected between the first battery terminal B1 and a ground GND in series, and may include a second resistor T2 and a second insulated switch SW2 connected between the second battery terminal B2 and the ground GND in series.

The battery pack 100 may include a controller 120 that controls the first insulated switch SW1 and the second insulated switch SW2. The controller 120 may detect a first battery voltage VB1 between the first battery terminal B1 and the ground GND, a second battery voltage VB2 between the second battery terminal B2 and the ground GND, a first terminal voltage VT1 between the first pack terminal T1 and the ground GND, and a second terminal voltage VT2 between the second pack terminal T2 and the ground GND.

The battery 110 may have a rated voltage of, for example, about 400 V or higher. An electric device or a charging device using a high voltage may be connected to the first pack terminal T1 and to the second pack terminal T2. For example, the battery pack 100 may be included in an electric vehicle, and the first pack terminal T1 and the second pack terminal T2 may be connected to an electric load, such as a driving motor of the electric vehicle. According to one or more other embodiments, the battery pack 100 may be included in an energy storage system.

The battery 100 may include the battery cells C₁ to Cₙ connected between the first battery terminal B1 and the second battery terminal B2. FIG. 1 shows that the battery cells C₁ to Cₙ are connected in series, but this is merely an example. The battery cells C₁ to Cₙ may be connected in series and in parallel.

It is assumed that the potential of the first battery terminal B1 with respect to the ground GND is +HV, and that the potential of the second battery terminal B2 is - HV. In this regard, in the present specification, the potential (+HV) at the first battery terminal B1 is assumed to have approximately the same intensity as the potential (-HV) at the second battery terminal (B2). However, this is merely an example. In general, because cell voltages of the battery cells C₁ to Cₙ are different, the intensity of the potential (+HV) at the first battery terminal B1 may not be exactly identical to the intensity of the potential (-HV) at the second battery terminal B2.

The battery 110 may output a voltage of 2(HV) (e.g., +HV-(-HV)). The potential at the ground GND may be substantially in the middle of the potential at the first battery terminal B1 and the potential at the second battery terminal B2. The ground GND may be connected to a ground pin of the controller 120 and to a ground of an electrical device connected through the first pack terminal T1 and through the second pack terminal T2. For example, the ground GND may be connected to the chassis of an electric vehicle connected through the first pack terminal T1 and through the second pack terminal T2. In one or more embodiments, the ground GND may be referred to as a chassis ground or an LV ground.

The battery cells C₁ to Cₙ may each be a rechargeable secondary cell storing power therein. For example, the battery cells C₁ to Cₙ may include at least one selected from the group including a lithium ion battery, a lithium polymer battery, a nickel cadmium battery, a nickel metal hydride (Ni-MH) battery, or a nickel-zinc (Ni-Zn) battery. The number and connection configurations of the battery cells C₁ to Cₙ may be determined according to an output voltage and a power storage capacity that is suitable for the battery pack 100. Hereinafter, the number of battery cells C₁ to Cₙ may be assumed to be n.

The battery pack 100 may include a plurality of battery modules. For example, the battery 110 may include a plurality of battery cell strings, and each battery cell string may include a plurality of battery cells. At least one battery cell string may be included in a battery module.

FIG. 1 shows that the first battery terminal B1 of the battery pack 100 is an anode, and that the second battery terminal B2 is a cathode. However, this is merely an example. The first battery terminal B1 may be a cathode, and the second battery terminal B2 may be an anode.

The first main switch SW1 may be configured to control the flow of charging and discharging currents of the battery 110, and may be a high-voltage relay switch. The second main switch SW2 may also be configured to control the flow of charging and discharging currents of the battery 110, and may be a high-voltage relay switch. FIG. 1 shows that the battery pack 100 includes the first main switch SW1 and the second main switch MS2, but the battery pack 100 may include only one of the first main switch SW1 and the second main switch MS2.

The first main switch SW1 and the second main switch MS2 may be controlled by the controller 120. For example, the first main switch SW1 and/or the second main switch MS2 may be opened or closed by a switch driver that is controlled by the controller 120.

In one or more embodiments, the battery pack 100 may further include a precharge switch and a precharge resistor that are connected in series. The precharge switch and the precharge resistor may be connected to the first main switch MS1 or the second main switch MS2 in parallel. The battery pack 100 may further include a current sensor for detecting the charging and/or discharging currents of the battery 110, and may also include a fuse in a high-current path through which the charging and discharging currents of the battery 110 flow. At least one of the current sensor and the fuse may be connected between the first pack terminal T1 and the first battery terminal B1, or between the second pack terminal T2 and the second battery terminal B2.

The first resistor R1 and the first insulated switch SW1 may be connected between the first battery terminal B1 and the ground GND in series. The second resistor R2 and the second insulated switch SW2 may be connected between the second battery terminal B2 and the ground GND in series. The first resistor R1 and the second resistor R2 may have the same resistance value. The first resistor R1 and the second resistor R2 may each have a value of, for example, about 500 kΩ. According to one or more other embodiments, the first resistor R1 and the second resistor R2 may each have a value of, for example, about 200 kΩ.

The first insulated switch SW1 and the second insulated switch SW2 may each be a semiconductor switch, for example, a MOSFET switch, which is controlled by the controller 120. According to one or more other embodiments, the first insulated switch SW1 and the second insulated switch SW2 may each be a relay switch.

If the first insulated switch SW1 is closed, the first battery terminal B1 may be connected to the ground GND, and the potential at the second battery terminal B2 may be about -2(HV). If the second insulated switch SW2 is closed, the second battery terminal B2 may be connected to the ground GND, and the potential at the first battery terminal B1 may be about +2(HV). The first insulated switch SW1 and the second insulated switch SW2 might not be simultaneously closed. In this regard, if the first insulated switch SW1 is closed, the second insulated switch SW2 may be opened. If the second insulated switch SW2 is closed, the first insulated switch SW1 may be opened. Both the first insulated switch SW1 and the second insulated switch SW2 may be opened.

In the present specification, a state in which the first insulated switch SW1 is closed and the second insulated switch SW2 is opened is referred to as a first state. A state in which the first insulated switch SW1 is opened and the second insulated switch SW2 is closed is referred to as a second state. The controller 120 may control the first insulated switch SW1 and the second insulated switch SW2 so that the first state and the second state may be alternately repeated. Between the first state and the second state, and/or between the second state and the first state, there may be a section in which both the first insulated switch SW1 and the second insulated switch SW2 are opened.

The battery pack 100 may include a voltage sensor for sensing a first battery voltage VB1 between the first battery terminal B1 and the ground GND, a voltage sensor for sensing a second battery voltage VB2 between the second battery terminal B2 and the ground GND, a voltage sensor for sensing a first terminal voltage VT1 between the first pack terminal T1 and the ground GND, and a voltage sensor for sensing a second terminal voltage VT2 between the second pack terminal T2 and the ground GND. The controller 120 may detect the first battery voltage VB1, the second battery voltage VB2, the first terminal voltage VT1, and the second terminal voltage VT2 through the voltage sensors.

The controller 120 may be configured to open the first main switch MS1, and to determine the welding of the first main switch MS1 based on a difference between the first terminal voltage VT1 in the first state, in which the first insulated switch SW1 is closed and the second insulated switch SW2 is opened, and the first terminal voltage VT1 in the second state, in which the first insulated switch SW1 is opened and the second insulated switch SW2 is closed.

According to embodiments, the controller 120 may determine that the first main switch MS1 malfunctions (e.g., is welded) if an absolute value of a variation in the first terminal voltage VT1 upon changing from the first state to the second state is greater than a threshold value (e.g., preset threshold value). The controller 120 may determine that the first main switch MS1 is welded if an absolute value of a variation in the first terminal voltage VT1 upon changing the second state to the first state is greater than the threshold value (e.g., preset threshold value).

The controller 120 may be configured to open the second main switch MS2, and to determine the welding of the second main switch MS2 based on a difference between the second terminal voltage VT2 in the first state, in which the first insulated switch SW1 is closed and the second insulated switch SW2 is opened, and the second terminal voltage VT2 in the second state, in which the first insulated switch SW1 is opened and the second insulated switch SW2 is closed.

According to embodiments, the controller 120 may determine that the second main switch MS2 is welded if an absolute value of a variation in the second terminal voltage VT2 during the transition from the first state to the second state, or from the second state to the first state, is greater than the threshold value (e.g., preset threshold value).

The controller 120 may be configured to close the first main switch MS1, and to determine whether the first main switch MS1 malfunctions based on a difference between a variation in the first battery voltage VB1 and a variation in the first terminal voltage VT1 during the transition from the first state to the second state, or from the second state to the first state.

The controller 120 may be configured to close the second main switch MS2, and to determine whether the second main switch MS2 malfunctions based on a difference between a variation in the second battery voltage VB2 and a variation in the second terminal voltage VT2 during the transition from the first state to the second state, or from the second state to the first state.

In one or more embodiments, the controller 120 may detect the cell voltages of the battery cells C₁ to Cₙ of the battery 110. The controller 120 may equalize the cell voltages of the battery cells C₁ to Cₙ by using a cell-balancing circuit. The controller 120 may use an analog front end to detect the cell voltages of the battery cells C₁ to Cₙ, and may perform cell balancing. The controller 120 may detect the battery temperature by using at least one temperature sensor in the battery pack 100. The controller 120 may perform data communication with an electric device that receives power stored in the battery 110 by using the pack terminals T1 and T2.

Because the voltage of the battery 110 is high, which is about several hundred volts (V) or higher, large currents may substantially instantaneously flow if the first main switch MS1 and the second main switch MS2 are opened and closed. In one or more embodiments, a link capacitor may be arranged between the first pack terminal T1 and the second pack terminal T2, and if the first main switch MS1 and the second main switch MS2 are closed, an inrush current may substantially instantaneously flow to charge the link capacitor.

Because of the large currents that substantially instantaneously flow, arcs may be generated, and the generated arcs may cause the welding of one or more contacts of the first main switch MS1 and/or the second main switch MS2. The substantially instantaneous large currents may lead to the generation of great heat between the contacts of the first main switch MS1 and the second main switch MS2, and the heat may result in the melting of the contacts.

If one or more of the contacts of the first main switch MS1 and the second main switch MS2 are welded, the first main switch MS1 and the second main switch MS2 may not be controlled by the controller 120, and a protection operation for the battery pack 100 might not be performed. In this regard, it may be impossible to separate the battery 110 from an electricity load or from a charging device despite the overheating of the battery 110, which may lead to the explosion of the battery 110. It may be desirable to accurately diagnose the welding of the contacts of the first main switch MS1 and the second main switch MS2.

According to the related art, a controller determines whether a high-voltage relay switch of a battery pack is welded based on voltages. For example, the controller compares a battery voltage, which is obtained by adding cells voltages of battery cells while the high-voltage relay switch is opened, with a terminal voltage between pack terminals, and if a difference between the battery voltage and the terminal voltage is less than a threshold value (e.g., preset threshold value), the controller may determine that the welding occurs in the high-voltage relay switch.

In one or more embodiments, there may be a vulnerability in the sensing values of the voltages used for the welding diagnosis, as the voltages may be influenced by the state of an electrical system or a battery system of an electric vehicle connected to the pack terminals. If a certain corner case occurs, it may result in an incorrect diagnostic outcome. For example, if electric charges reside in the link capacitor between the pack terminals, a certain voltage may appear between the pack terminals because of the link capacitor even after the high-voltage relay switch is opened, and if the terminal voltage between the pack terminals is high enough to reach the battery voltage, the controller may diagnose that the high-voltage relay switch is welded. As described, if a false positive diagnosis of welding occurs on the high-voltage relay switch even if no welding has taken place, there may be an error triggering a safety mode during which the electric vehicle is completely inoperable.

To overcome the above problem, various methods may be employed if a misdiagnosis is concerned, wherein examples of the methods include omitting the welding diagnosis, adjusting the threshold value, and delaying the point in time if the diagnosis is made after the relay switch is opened. The aforementioned methods may lead to a false-negative diagnosis issue as they fail to detect the actual welding of the relay switch, even if the welding has occurred.

Hereinafter, a method of accurately diagnosing the welding of the main switch according to the present disclosure is described.

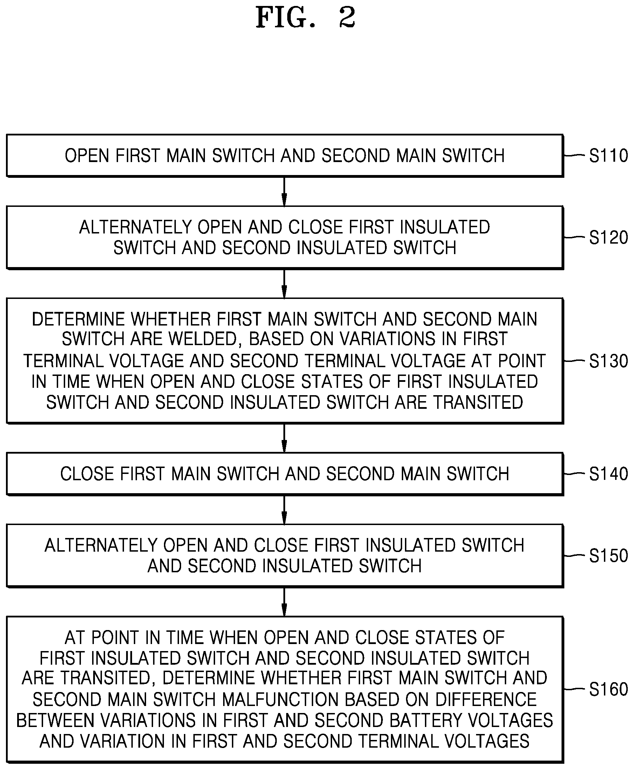

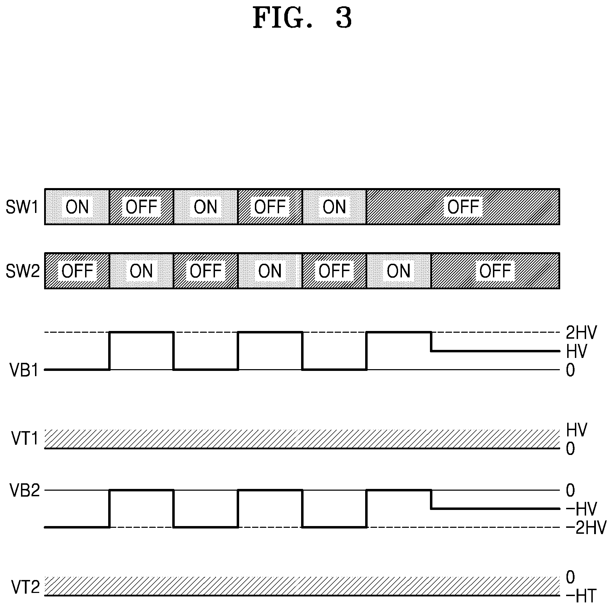

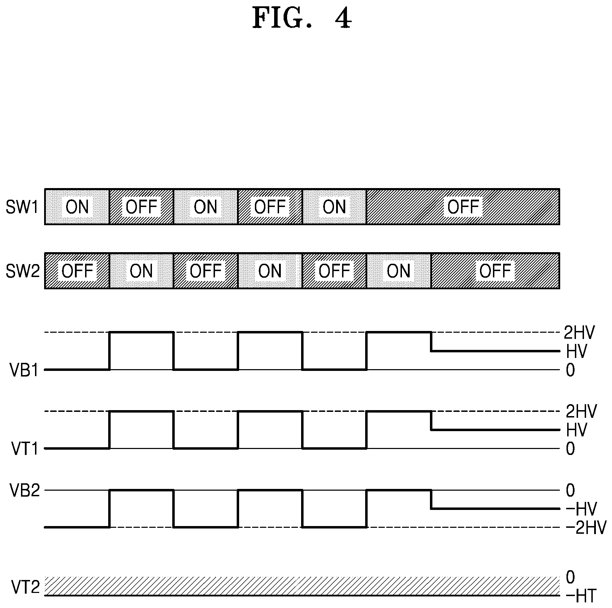

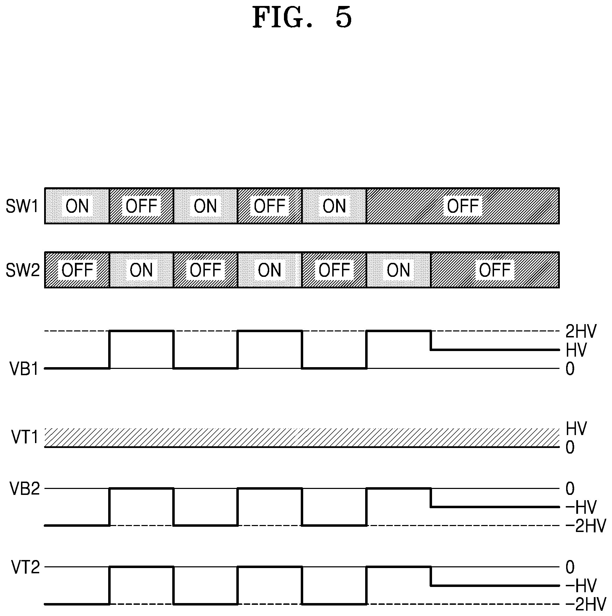

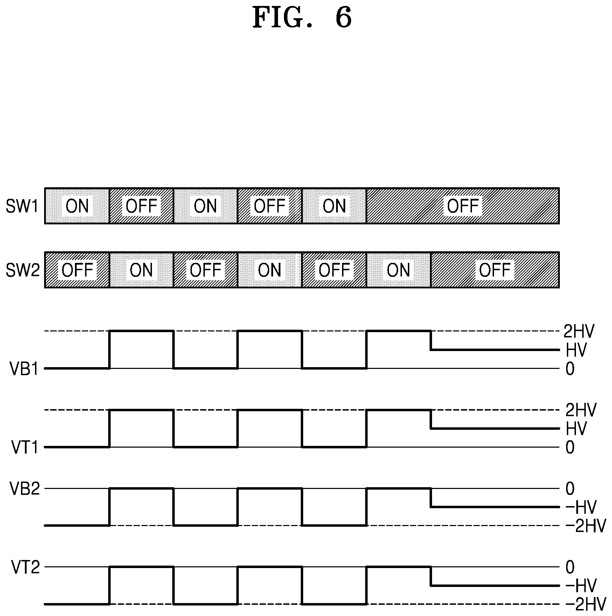

FIG. 2 is a flowchart for explaining a method of diagnosing whether a main switch of a battery pack is welded, according to embodiments of the present disclosure. FIG. 3 shows an example of first and second battery voltages and first and second terminal voltages based on states of first and second insulated switches of a battery pack with opened first and second main switches, according to embodiments of the present disclosure. FIG. 4 shows an example of first and second battery voltages and first and second terminal voltages based on states of first and second insulated switches of a battery pack with a welded first main switch, according to embodiments of the present disclosure. FIG. 5 shows an example of first and second battery voltages and first and second terminal voltages based on states of first and second insulated switches of a battery pack with a welded second main switch, according to embodiments of the present disclosure. FIG. 6 shows an example of first and second battery voltages and first and second terminal voltages based on states of first and second insulation switches of a battery pack with closed first and second main switches, according to embodiments of the present disclosure.

Referring to FIGS. 1 and 2 together, the controller 120 may open the first main switch MS1 and the second main switch MS2, in operation S110.

The controller 120 may alternately open and close the first insulated switch SW1 and the second insulated switch SW2, in operation S120. According to embodiments, the controller 120 may control the first insulated switch SW1 and the second insulated switch SW2 to alternately repeat the first state, in which the first insulated switch SW1 is closed and the second insulated switch SW2 is opened, and the second state, in which the first insulated switch SW1 is opened and the second insulated switch SW2 is closed.

As shown in FIGS. 3 to 6, for example, the controller 120 may close the first insulated switch SW1 and open the second insulated switch SW2 for a first temporal section, and may open the first insulated switch SW1 and close the second insulated switch SW2 for a second temporal section. The controller 120 may control the first insulated switch SW1 and the second insulated switch SW2 in the first state after the second temporal section. The controller 120 may control the first insulated switch SW1 and the second insulated switch SW2 to alternately repeat the first state and the second state in the above-described manner.

In operation S130, the controller 120 may determine whether the first main switch MS1 and the second main switch MS2 are welded, based on variations in the first terminal voltage VT1 and the second terminal voltage VT2 at a point in time in which respective open and close states of the first main switch MS1 and the second main switch MS2 change.

According to embodiments, during the respective state transitions of the first and second insulated switches SW1 and SW2 from the first state to the second state, or from the second state to the first state, the controller 120 may determine that the first main switch MS1 is welded if the absolute value of the variation in the first terminal voltage VT1 is greater than the threshold value (e.g., preset threshold value), and may determine that the second main switch MS2 is welded if the absolute value of the variation in the second terminal voltage VT2 is greater than the threshold value (e.g., preset threshold value).

For example, the controller 120 may determine that the first main switch MS1 is welded if the difference between the first terminal voltage VT1 in the first state and the first terminal voltage VT1 in the second state is greater than the threshold value (e.g., preset threshold value). The controller 120 may determine that the second main switch MS2 is welded if the difference between the second terminal voltage VT2 in the first state and the second terminal voltage VT2 in the second state is greater than the threshold value (e.g., preset threshold value).

Referring to FIG. 3, because the first battery terminal B1 is connected to the ground GND in the first state in which the first insulated switch SW1 is closed and the second insulated switch SW2 is opened, the first battery voltage VB1 may be about 0 and the second battery voltage VB2 may be about -2(HV).

If the first main switch MS1 and the second main switch MS2 are normally opened, the first pack terminal T1 and the second pack terminal T2 are respectively insulated from the first battery terminal B1 and the second battery terminal B2, and the first terminal voltage VT1 and the second terminal voltage VT2 may be unaffected by the states of the first insulated switch SW1 and the second insulated switch SW2. If all of the electric charges in the link capacitor between the pack terminals T1 and T2 are discharged, both the first terminal voltage VT1 and the second terminal voltage VT2 may be about 0, and if the electric charges in the link capacitor remain charged, the first terminal voltage VT1 may be about +HV, and the second terminal voltage VT2 may be about -HV. The first terminal voltage VT1 may be between about 0 and about +HV, and the second terminal voltage VT2 may be between about 0 and about -HV.

During the transition to the second state, in which the first insulated switch SW1 is opened and the second insulated switch SW2 is closed, the second battery terminal B2 is connected to the ground GND such that the first battery voltage VB1 may increase to about +2(HV), and such that the second battery voltage VB2 may increase to 0. In one or more embodiments, if the first main switch MS1 and the second main switch MS2 are normally opened, the first pack terminal T1 and the second pack terminal T2 are respectively insulated from the first battery terminal B1 and the second battery terminal B2, and the first terminal voltage VT1 and the second terminal voltage VT2 may remain in the previous states regardless of the states of the first insulated switch SW1 and the second insulated switch SW2.

If the state is transitioned again to the first state, in which the first insulated switch SW1 is closed and the second insulated switch SW2 is opened, the first battery terminal B1 is connected to the ground GND, such that the first battery voltage VB1 may decrease to about 0, and such that the second battery voltage VB2 may decrease to about -2(HV). In one or more embodiments, if the first main switch MS1 and the second main switch MS2 are normally opened, the first pack terminal T1 and the second pack terminal T2 are respectively insulated from the first battery terminal B1 and the second battery terminal B2, and the first terminal voltage VT1 and the second terminal voltage VT2 may remain in the previous states regardless of the states of the first insulated switch SW1 and the second insulated switch SW2.

Referring to FIG. 4, if the first main switch MS1 is welded, the first terminal voltage VT1 may increase from about 0 to about +2(HV) during the transition from the first state to the second state in sync with the increase in the first battery voltage VB1. The variation (e.g., +2(HV)) in the first terminal voltage VT1 is greater than the threshold value (e.g., preset threshold value, which may be HV) during the transition from the first state to the second state, and the controller 120 may determine that the first main switch MS1 is welded.

Also, if the second state is transitioned to the first state, the first terminal voltage VT1 may decrease from about +2(HV) to about 0, aligning with the decrease in the first battery voltage VB1. Because the absolute value (e.g., 2(HV)) of the variation (e.g., -2(HV)) of the first terminal voltage VT1 is greater than the threshold value (e.g., preset threshold value, which may be HV) during the transition from the second state to the first state, the controller 120 may determine that the first main switch MS1 is welded.

As shown in FIG. 5, if the second main switch MS2 is welded, the second terminal voltage VT2 may increase from about -2(HV) to about 0 during the transition from the first state to the second state, aligning with the increase in the second battery voltage VB2. If the variation (e.g., +2(HV)) in the second terminal voltage VT2 is greater than the threshold value (e.g., preset threshold value, which may be HV) during the transition from the first state to the second state, the controller 120 may determine that the second main switch MS2 is welded.

Also, if the second state is transitioned to the first state, the second terminal voltage VT2 may decrease from about 0 to about -2(HV) in sync with the decrease in the second battery voltage VB2. Because the absolute value (e.g., 2(HV)) of the variation (e.g., -2(HV)) of the second terminal voltage VT2 is greater than the threshold value (e.g., preset threshold value, which may be HV) during the transition from the second state to the first state, the controller 120 may determine that the second main switch MS2 is welded.

Referring back to FIG. 2, the controller 120 may close the first main switch MS1 and the second main switch MS2, in operation S140.

In operation S150, the controller 120 may alternately open and close the first insulated switch SW1 and the second insulated switch SW2 in the same manner as in operation S120.

In operation S160, the controller 120 may determine whether the first main switch MS1 and the second main switch MS2 malfunction, based on a difference between the variations in the first battery voltage VB1 and the second battery voltage VB2 and the variations in the first terminal voltage VT1 and the second terminal voltage VT2 at the point in time that the open and close states of the first insulated switch SW1 and the second insulated switch SW2 change.

According to embodiments, if the states of the first insulated switch SW1 and the second insulated switch SW2 are transitioned from the first state to the second state, or from the second state to the first state, the controller 120 may determine that the first main switch MS1 malfunctions if the difference between the variation in the first battery voltage VB1 and the variation in the first terminal voltage VT1 is greater than the threshold value (e.g., preset threshold value), and may determine that the second main switch MS2 malfunctions if the difference between the variation in the second battery voltage VB2 and the variation in the second terminal voltage VT2 is greater than the threshold value (e.g., preset threshold value).

Referring to FIG. 6, because the first battery terminal B1 is connected to the ground GND in the first state in which the first insulated switch SW1 is closed and the second insulated switch SW2 is opened, the first battery voltage VB1 may be about 0 and the second battery voltage VB2 may be about -2(HV).

If the first state is transitioned to the second state in which the first insulated switch SW1 is opened and the second insulated switch SW2 is closed, because the second battery terminal B2 is connected to the ground GND, the first battery voltage VB1 may increase to about +2(HV), and the second battery voltage VB2 may increase to about 0.

If the second state is transitioned again to the first state in which the first insulated switch SW1 is closed and the second insulated switch SW2 is opened, because the first battery terminal B1 is connected to the ground GND, the first battery voltage VB1 may decrease to about 0, and the second battery voltage VB2 may decrease to about -2(HV).

If the first main switch MS1 and the second main switch MS2 are normally closed, the first pack terminal T1 and the second pack terminal T2 are respectively connected to the first battery terminal B1 and the second battery terminal B2, and the first terminal voltage VT1 may be substantially equal to the first battery voltage VB1, and the second terminal voltage VT2 may be substantially equal to the second battery voltage VB2. If the states of the first insulated switch SW1 and the second insulated switch SW2 are transitioned from the first state to the second state, or from the second state to the first state, the variation in the first battery voltage VB1 may be substantially identical to that in the first terminal voltage VT1, and the variation in the second battery voltage VB2 may be substantially identical to that in the second terminal voltage VT2. Because the difference between the variation in the first battery voltage VB1 and the variation in the first terminal voltage VT1 is less than the threshold value (e.g., preset threshold value), the controller 120 may determine that the first main switch MS1 is normally closed. Because the difference between the variation in the second battery voltage VB2, and the variation in the second terminal voltage VT2 is less than the threshold value (e.g., preset threshold value), the controller 120 may determine that the second main switch MS2 is normally closed. The threshold value (e.g., preset threshold value) may be then about HV.

Referring to FIG. 5, if the first main switch MS1 is not closed because of the malfunction thereof, because the first pack terminal T1 is insulated from the first battery terminal B1, the first terminal voltage VT1 may not be influenced by the states of the first insulated switch SW1 and the second insulated switch SW2. In this regard, during the transition from the first state to the second state, the first terminal voltage VT1 may still have the existing value despite the increase in the first battery voltage VB1 from about 0 to about +2(HV). Because the difference between the variation (e.g., +2(HV)) in the first battery voltage VB1 and the variation (e.g., 0) in the first terminal voltage VT1 is greater than the threshold value (e.g., preset threshold value, which may be HV), the controller 120 may determine that the first main switch MS1 malfunctions.

During the transition from the second state to the first state, the first terminal voltage VT1 may still have the existing value despite the decrease in the first battery voltage VB1 from about +2(HV) to about 0. Because the difference between the variation (e.g., -2(HV)) in the first battery voltage VB1 and the variation (e.g., 0) in the first terminal voltage VT1 is greater than the threshold value (e.g., preset threshold value, which may be HV), the controller 120 may determine that the first main switch MS1 malfunctions.

Referring to FIG. 4, if the second main switch MS2 is not closed because of the malfunction thereof, because the second pack terminal T2 is insulated from the second battery terminal B2, the second terminal voltage VT2 may not be influenced by the states of the first insulated switch SW1 and the second insulated switch SW2. In this regard, during the transition from the first state to the second state, the second terminal voltage VT2 may still have the existing value despite the increase in the second battery voltage VB2 from about -2(HV) to about 0. Because the difference between the variation (e.g., +2(HV)) in the second battery voltage VB2 and the variation (e.g., 0) in the second terminal voltage VT2 is greater than the threshold value (e.g., preset threshold value, which may be HV), the controller 120 may determine that the second main switch MS2 malfunctions.

Also, during the transition from the second state to the first state, the second terminal voltage VT2 may still have the existing value despite the decrease in the second battery voltage VB2 from about 0 to about -2(HV). Because the difference between the variation (e.g., -2(HV)) in the second battery voltage VB2 and the variation (e.g., 0) in the second terminal voltage VT2 is greater than the threshold value (e.g., preset threshold value, which may be HV), the controller 120 may determine that the second main switch MS2 malfunctions.

The embodiments shown and described herein are only examples of the present disclosure, and are not intended to otherwise limit the scope of the present disclosure in any way. For the sake of brevity, existing electronics, control systems, software development, and other functional aspects of the systems may not be described in detail. Furthermore, the connecting lines, or connectors shown in the various figures presented, are intended to represent functional relationships and/or physical or logical couplings between the various elements, and it should be noted that many alternative or additional functional relationships, physical connections, or logical connections may be present in a practical device.

The use of the terms "a" and "an" and "the" and similar referents in the context of describing the present disclosure (especially in the context of the following claims) are to be construed to cover both the singular and the plural. Furthermore, recitation of ranges of values herein are merely intended to serve as a shorthand method of referring individually to each separate value falling within the range, unless otherwise indicated herein, and each separate value is incorporated into the specification as if it were individually recited herein. Also, the steps of all methods described herein can be performed in any suitable order unless otherwise indicated herein or otherwise clearly contradicted by context. The present disclosure is not limited to the described order of the steps.

The use of any and all examples, or language (e.g., "such as") provided herein, is intended merely to better illuminate the present disclosure, and does not pose a limitation on the scope of the present disclosure unless otherwise claimed. Numerous modifications and adaptations will be readily apparent to one of ordinary skill in the art without departing from the scope of the present disclosure.

Embodiments are presented herein, and although specific terms are employed, they are not used for the purpose of limitation and should be interpreted as being generic and descriptive. In some embodiments, it will be clear to one of ordinary skill in the art at the time of filing the application that the aspects and/or components described in connection with the described embodiments may be used alone, unless otherwise specifically stated, or may be used together with the aspects and/or components described in connection with other embodiments. Accordingly, the present disclosure is not limited to the above-described embodiments, and all ranges equivalent to or equivalently changed from the claims described later are construed as being included in the scope of the present disclosure.

According to one or more embodiments, the likelihood of a misdiagnosis regarding the welding of a high-voltage relay switch may be reduced or prevented. Through the improvement in the diagnosis reliability of the high-voltage relay switch, the accurate welding diagnosis may be achieved even in situations in which monitoring a voltage, which is a welding diagnosis factor, is unstable.

It should be understood that embodiments described herein should be considered in a descriptive sense only and not for purposes of limitation. Descriptions of aspects within each embodiment should typically be considered as available for other similar aspects in other embodiments. While one or more embodiments have been described with reference to the figures, it will be understood by those of ordinary skill in the art that various changes in form and details may be made therein without departing from the scope of the invention as defined by the following claims.

## Claims

1. A battery pack (100) comprising:
a first pack terminal (T1);
a second pack terminal (T2);
a battery (110) comprising battery cells (C₁ to Cₙ) between a first battery terminal (B1) and a second battery terminal (B2);
a first main switch (MS1) between the first pack terminal (T1) and the first battery terminal (B1);
a first resistor (R1) and a first insulated switch (SW1) connected in series between the first battery terminal (B1) and a ground (GND);
a second resistor (R2) and a second insulated switch (SW2) connected in series between the second battery terminal (B1) and the ground (GND); and
a controller (120);
**characterized in that** the controller (120) is configured to:
control the first insulated switch (SW1) and the second insulated switch (SW2) to alternately repeat a first state, in which the first insulated switch (SW1) is closed and the second insulated switch (SW2) is opened, and a second state, in which the first insulated switch (SW1) is opened and the second insulated switch (SW2) is closed;
detect a first terminal voltage between the first pack terminal (T1) and the ground (GND) ;
open the first main switch (MS1); and
determine whether the first main switch (MS1) malfunctions based on a difference between the first terminal voltage in the first state and the first terminal voltage in the second state.

2. The battery pack (100) as claimed in claim 1, wherein the controller (120) is further configured to determine that the first main switch (MS1) malfunctions based on an absolute value of a variation in the first terminal voltage from the first state to the second state being greater than a threshold value.

3. The battery pack (100) as claimed in claim 2, wherein the controller (120) is further configured to determine that the first main switch (MS1) malfunctions based on an absolute value of a variation in the first terminal voltage from the second state to the first state being greater than the threshold value.

4. The battery pack (100) as claimed in any one of the preceding claims, further comprising a second main switch (MS2) between the second pack terminal (T2) and the second battery terminal (B2),
wherein the controller (120) is further configured to:
detect a second terminal voltage between the second pack terminal (T2) and the ground (GND);
open the second main switch (MS2); and
determine whether the second main switch (MS2) malfunctions based on a difference between the second terminal voltage in the first state and the second terminal voltage in the second state.

5. The battery pack (100) as claimed in claim 4, wherein the controller (120) is further configured to:
open the first main switch (MS1) and the second main switch (MS2); and
determine that the first main switch (MS1) malfunctions based on an absolute value of a variation in the first terminal voltage being greater than a threshold value, or determine that the second main switch (MS2) malfunctions based on an absolute value of a variation in the second terminal voltage being greater than the threshold value, during a transition from the first state to the second state, or from the second state to the first state.

6. The battery pack (100) as claimed in any one of the preceding claims, wherein the controller (120) is further configured to:
detect a first battery voltage between the first battery terminal (B1) and the ground (GND);
close the first main switch (MS1); and
determine whether the first main switch (MS1) malfunctions based on a difference between a variation in the first battery voltage and a variation in the first terminal voltage during a transition from the first state to the second state, or from the second state to the first state.

7. The battery pack (100) as claimed in any one of the preceding claims, wherein the controller (120) is further configured to:
detect a second battery voltage between the second battery terminal (B1) and the ground (GND);
detect a second terminal voltage between the second pack terminal (T1) and the ground (GND);
close a second main switch (MS2) between the second pack terminal (T2) and the second battery terminal (B2); and
determine whether the second main switch (MS2) malfunctions based on a difference between a variation in the second battery voltage and a variation in the second terminal voltage during a transition from the first state to the second state, or from the second state to the first state.

8. A method of operating a battery pack (100) comprising a battery (110), a first main switch (MS1) between a first pack terminal (T1) and a first battery terminal (B1), a second main switch (MS2) between a second pack terminal (T2) and a second battery terminal (B2), a first resistor (R1) and a first insulated switch (SW1) connected in series between the first battery terminal (B1) and a ground (GND), and a second resistor (R2) and a second insulated switch (SW2) connected in series between the second battery terminal (B2) and the ground (GND), the method comprising:
opening the first main switch (MS1);
controlling the first insulated switch (SW1) and the second insulated switch (SW2) to alternately repeat a first state, in which the first insulated switch (SW1) is closed and the second insulated switch (SW2) is opened, and a second state, in which the first insulated switch (SW1) is opened and the second insulated switch (SW2) is closed;
detecting a first terminal voltage between the first pack terminal (T1) and the ground (GND); and
determining whether the first main switch (MS1) malfunctions based on a difference between the first terminal voltage in the first state and the first terminal voltage in the second state.

9. The method as claimed in claim 8, further comprising:
opening the second main switch (MS2);
detecting a second terminal voltage between the second pack terminal (T2) and the ground (GND); and
determining whether the second main switch (MS2) malfunctions based on a difference between the second terminal voltage in the first state and the second terminal voltage in the second state.

10. The method as claimed in claim 8 or claim 9, further comprising:
closing the first main switch (MS1);
controlling the first insulated switch (SW1) and the second insulated switch (SW2) to alternately repeat the first state, in which the first insulated switch (SW1) is closed and the second insulated switch (SW2) is opened, and the second state, in which the first insulated switch (SW1) is opened and the second insulated switch (SW2) is closed;
detecting a first battery voltage between the first battery terminal (B1) and the ground (GND);
detecting the first terminal voltage between the first pack terminal (T1) and the ground (GND); and
determining whether the first main switch (MS1) malfunctions based on a difference between a variation in the first battery voltage and a variation in the first terminal voltage between the first state and the second state.

11. The method as claimed in claim 10, further comprising:
closing the second main switch (MS2);
detecting a second battery voltage between the second battery terminal (B2) and the ground (GND);
detecting a second terminal voltage between the second pack terminal (T2) and the ground (GND); and
determining whether the second main switch (MS2) malfunctions based on a difference between a variation in the second battery voltage and a variation in the second terminal voltage between the first state and the second state.

## Patentansprüche

1. Batteriepack (100), umfassend:
einen ersten Pack-Anschluss (T1);
einen zweiten Pack-Anschluss (T2);
eine Batterie (110), umfassend Batteriezellen (C₁ bis Cₙ) zwischen einem ersten Batterieanschluss (B1) und einem zweiten Batterieanschluss (B2);
einen ersten Hauptschalter (MS1) zwischen dem ersten Pack-Anschluss (T1) und dem ersten Batterieanschluss (B1);
einen ersten Widerstand (R1) und einen ersten isolierten Schalter (SW1), die in Reihe zwischen dem ersten Batterieanschluss (B1) und Masse (GND) geschaltet sind;
einen zweiten Widerstand (R2) und einen zweiten isolierten Schalter (SW2), die in Reihe zwischen dem zweiten Batterieanschluss (B1) und Masse (GND) geschaltet sind; und
eine Steuereinheit (120);
**dadurch gekennzeichnet, dass** die Steuereinheit (120) konfiguriert ist zum:
Steuern des ersten isolierten Schalters (SW1) und des zweiten isolierten Schalters (SW2) zum abwechselnden Wiederholen eines ersten Zustands, in dem der erste isolierte Schalter (SW1) geschlossen und der zweite isolierte Schalter (SW2) geöffnet ist, und eines zweiten Zustands, in dem der erste isolierte Schalter (SW1) geöffnet und der zweite isolierte Schalter (SW2) geschlossen ist;
Erfassen einer ersten Anschlussspannung zwischen dem ersten Pack-Anschluss (T1) und Masse (GND);
Öffnen des ersten Hauptschalters (MS1); und
Ermitteln anhand einer Differenz zwischen der ersten Anschlussspannung im ersten Zustand und der ersten Anschlussspannung im zweiten Zustand, ob der erste Hauptschalter (MS1) eine Fehlfunktion aufweist.

2. Batteriepack (100) nach Anspruch 1, wobei die Steuereinheit (120) weiter so konfiguriert ist, dass sie anhand dessen, dass ein absoluter Wert einer Änderung der ersten Anschlussspannung vom ersten Zustand zum zweiten Zustand größer als ein Schwellenwert ist, ermittelt, dass der erste Hauptschalter (MS1) eine Fehlfunktion aufweist.

3. Batteriepack (100) nach Anspruch 2, wobei die Steuereinheit (120) weiter so konfiguriert ist, dass sie anhand dessen, dass ein absoluter Wert einer Änderung der ersten Anschlussspannung vom zweiten Zustand zum ersten Zustand größer als der Schwellenwert ist, ermittelt, dass der erste Hauptschalter (MS1) eine Fehlfunktion aufweist.

4. Batteriepack (100) nach einem der vorstehenden Ansprüche, weiter umfassend einen zweiten Hauptschalter (MS2) zwischen dem zweiten Pack-Anschluss (T2) und dem zweiten Batterieanschluss (B2),
wobei die Steuereinheit (120) weiter konfiguriert ist zum:
Erfassen einer zweiten Anschlussspannung zwischen dem zweiten Pack-Anschluss (T2) und Masse (GND);
Öffnen des zweiten Hauptschalters (MS2); und
Ermitteln anhand einer Differenz zwischen der zweiten Anschlussspannung im ersten Zustand und der zweiten Anschlussspannung im zweiten Zustand, ob der zweite Hauptschalter (MS2) eine Fehlfunktion aufweist.

5. Batteriepack (100) nach Anspruch 4, wobei die Steuereinheit (120) weiter konfiguriert ist zum:
Öffnen des ersten Hauptschalters (MS1) und des zweiten Hauptschalters (MS2); und
Ermitteln anhand dessen, dass ein absoluter Wert einer Änderung der ersten Anschlussspannung größer als ein Schwellenwert ist, dass der erste Hauptschalter (MS1) eine Fehlfunktion aufweist, oder Ermitteln anhand dessen, dass ein absoluter Wert einer Änderung der zweiten Anschlussspannung größer als der Schwellenwert ist, dass der zweite Hauptschalter (MS2) eine Fehlfunktion aufweist, während eines Übergangs vom ersten Zustand zum zweiten Zustand oder vom zweiten Zustand zum ersten Zustand.

6. Batteriepack (100) nach einem der vorstehenden Ansprüche, wobei die Steuereinheit (120) weiter konfiguriert ist zum:
Erfassen einer ersten Batteriespannung zwischen dem ersten Batterieanschluss (B1) und Masse (GND);
Schließen des ersten Hauptschalters (MS1); und
Ermitteln anhand einer Differenz zwischen einer Änderung der ersten Batteriespannung und einer Änderung der ersten Anschlussspannung während eines Übergangs vom ersten Zustand zum zweiten Zustand oder vom zweiten Zustand zum ersten Zustand, ob der erste Hauptschalter (MS1) eine Fehlfunktion aufweist.

7. Batteriepack (100) nach einem der vorstehenden Ansprüche, wobei die Steuereinheit (120) weiter konfiguriert ist zum:
Erfassen einer zweiten Batteriespannung zwischen dem zweiten Batterieanschluss (B1) und Masse (GND);
Erfassen einer zweiten Anschlussspannung zwischen dem zweiten Pack-Anschluss (T1) und Masse (GND);
Schließen eines zweiten Hauptschalters (MS2) zwischen dem zweiten Pack-Anschluss (T2) und dem zweiten Batterieanschluss (B2); und
Ermitteln anhand einer Differenz zwischen einer Änderung der zweiten Batteriespannung und einer Änderung der zweiten Anschlussspannung während eines Übergangs vom ersten Zustand zum zweiten Zustand oder vom zweiten Zustand zum ersten Zustand, ob der zweite Hauptschalter (MS2) eine Fehlfunktion aufweist.

8. Verfahren zum Betreiben eines Batteriepacks (100), umfassend eine Batterie (110), einen ersten Hauptschalter (MS1) zwischen einem ersten Pack-Anschluss (T1) und einem ersten Batterieanschluss (B1), einen zweiten Hauptschalter (MS2) zwischen einem zweiten Pack-Anschluss (T2) und einem zweiten Batterieanschluss (B2), einen ersten Widerstand (R1) und einen ersten isolierten Schalter (SW1), die in Reihe zwischen dem ersten Batterieanschluss (B1) und Masse (GND) geschaltet sind, sowie einen zweiten Widerstand (R2) und einen zweiten isolierten Schalter (SW2), die in Reihe zwischen dem zweiten Batterieanschluss (B2) und Masse (GND) geschaltet sind, wobei das Verfahren Folgendes umfasst:
Öffnen des ersten Hauptschalters (MS1);
Steuern des ersten isolierten Schalters (SW1) und des zweiten isolierten Schalters (SW2) zum abwechselnden Wiederholen eines ersten Zustands, in dem der erste isolierte Schalter (SW1) geschlossen und der zweite isolierte Schalter (SW2) geöffnet ist, und eines zweiten Zustands, in dem der erste isolierte Schalter (SW1) geöffnet und der zweite isolierte Schalter (SW2) geschlossen ist;
Erfassen einer ersten Anschlussspannung zwischen dem ersten Pack-Anschluss (T1) und Masse (GND); und
Ermitteln anhand einer Differenz zwischen der ersten Anschlussspannung im ersten Zustand und der ersten Anschlussspannung im zweiten Zustand, ob der erste Hauptschalter (MS1) eine Fehlfunktion aufweist.

9. Verfahren nach Anspruch 8, weiter umfassend:
Öffnen des zweiten Hauptschalters (MS2);
Erfassen einer zweiten Anschlussspannung zwischen dem zweiten Pack-Anschluss (T2) und Masse (GND); und
Ermitteln anhand einer Differenz zwischen der zweiten Anschlussspannung im ersten Zustand und der zweiten Anschlussspannung im zweiten Zustand, ob der zweite Hauptschalter (MS2) eine Fehlfunktion aufweist.

10. Verfahren nach Anspruch 8 oder Anspruch 9, weiter umfassend:
Schließen des ersten Hauptschalters (MS1);
Steuern des ersten isolierten Schalters (SW1) und des zweiten isolierten Schalters (SW2) zum abwechselnden Wiederholen des ersten Zustands, in dem der erste isolierte Schalter (SW1) geschlossen und der zweite isolierte Schalter (SW2) geöffnet ist, und des zweiten Zustands, in dem der erste isolierte Schalter (SW1) geöffnet und der zweite isolierte Schalter (SW2) geschlossen ist;
Erfassen einer ersten Batteriespannung zwischen dem ersten Batterieanschluss (B1) und Masse (GND);
Erfassen der ersten Anschlussspannung zwischen dem ersten Pack-Anschluss (T1) und Masse (GND); und
Ermitteln anhand einer Differenz zwischen einer Änderung der ersten Batteriespannung und einer Änderung der ersten Anschlussspannung zwischen dem ersten Zustand und dem zweiten Zustand, ob der erste Hauptschalter (MS1) eine Fehlfunktion aufweist.

11. Verfahren nach Anspruch 10, weiter umfassend:
Schließen des zweiten Hauptschalters (MS2);
Erfassen einer zweiten Batteriespannung zwischen dem zweiten Batterieanschluss (B2) und Masse (GND);
Erfassen einer zweiten Anschlussspannung zwischen dem zweiten Pack-Anschluss (T2) und Masse (GND); und
Ermitteln anhand einer Differenz zwischen einer Änderung der zweiten Batteriespannung und einer Änderung der zweiten Anschlussspannung zwischen dem ersten Zustand und dem zweiten Zustand, ob der zweite Hauptschalter (MS2) eine Fehlfunktion aufweist.

## Revendications

1. Bloc-batterie (100) comprenant :
une première borne de bloc (T1) ;
une seconde borne de bloc (T2) ;
une batterie (110) comprenant des éléments de batterie (C₁ à Cₙ) entre une première borne de batterie (B1) et une seconde borne de batterie (B2) ;
un premier interrupteur principal (MS1) entre la première borne de bloc (T1) et la première borne de batterie (B1) ;
une première résistance (R1) et un premier interrupteur isolé (SW1) montés en série entre la première borne de batterie (B1) et une masse (GND) ;
une seconde résistance (R2) et un second interrupteur isolé (SW2) montés en série entre la seconde borne de batterie (B1) et la masse (GND) ; et
un dispositif de commande (120) ;
**caractérisé en ce que** le dispositif de commande (120) est configuré pour :
commander le premier interrupteur isolé (SW1) et le second interrupteur isolé (SW2) pour répéter alternativement un premier état, dans lequel le premier interrupteur isolé (SW1) est fermé et le second interrupteur isolé (SW2) est ouvert, et un second état, dans lequel le premier interrupteur isolé (SW1) est ouvert et le second interrupteur isolé (SW2) est fermé ;
détecter une première tension de borne entre la première borne de bloc (T1) et la masse (GND) ;
ouvrir le premier interrupteur principal (MS1) ; et
déterminer si le premier interrupteur principal (MS1) fonctionne mal sur la base d'une différence entre la première tension de borne dans le premier état et la première tension de borne dans le second état.

2. Bloc-batterie (100) selon la revendication 1, dans lequel le dispositif de commande (120) est en outre configuré pour déterminer que le premier interrupteur principal (MS1) fonctionne mal sur la base d'une valeur absolue d'une variation de la première tension de borne du premier état au second état étant supérieure à une valeur seuil.

3. Bloc-batterie (100) selon la revendication 2, dans lequel le dispositif de commande (120) est en outre configuré pour déterminer que le premier interrupteur principal (MS1) fonctionne mal sur la base d'une valeur absolue d'une variation de la première tension de borne du second état au premier état étant supérieure à la valeur seuil.

4. Bloc-batterie (100) selon l'une quelconque des revendications précédentes, comprenant en outre un second interrupteur principal (MS2) entre la seconde borne de bloc (T2) et la seconde borne de batterie (B2),
dans lequel le dispositif de commande (120) est en outre configuré pour :
détecter une seconde tension de borne entre la seconde borne de pack (T2) et la masse (GND) ;
ouvrir le second interrupteur principal (MS2) ; et
déterminer si le second interrupteur principal (MS2) fonctionne mal sur la base d'une différence entre la seconde tension de borne dans le premier état et la seconde tension de borne dans le second état.

5. Bloc-batterie (100) selon la revendication 4, dans lequel le dispositif de commande (120) est en outre configuré pour :
ouvrir le premier interrupteur principal (MS1) et le second interrupteur principal (MS2) ; et
déterminer que le premier interrupteur principal (MS1) fonctionne mal sur la base d'une valeur absolue d'une variation de la première tension de borne étant supérieure à une valeur seuil, ou déterminer que le second interrupteur principal (MS2) fonctionne mal sur la base d'une valeur absolue d'une variation de la seconde tension de borne étant supérieure à la valeur seuil, lors d'une transition du premier état au second état, ou du second état au premier état.

6. Bloc-batterie (100) selon l'une quelconque des revendications précédentes, dans lequel le dispositif de commande (120) est en outre configuré pour :
détecter une première tension de batterie entre la première borne de batterie (B1) et la masse (GND) ;
fermer le premier interrupteur principal (MS1) ; et
déterminer si le premier interrupteur principal (MS1) fonctionne mal sur la base d'une différence entre une variation de la première tension de batterie et une variation de la première tension de borne lors d'une transition du premier état au second état, ou du second état au premier état.

7. Bloc-batterie (100) selon l'une quelconque des revendications précédentes, dans lequel le dispositif de commande (120) est en outre configuré pour :
détecter une seconde tension de batterie entre la seconde borne de batterie (B1) et la masse (GND) ;
détecter une seconde tension de borne entre la seconde borne de bloc (T1) et la masse (GND) ;
fermer un second interrupteur principal (MS2) entre la seconde borne de bloc (T2) et la seconde borne de batterie (B2) ; et
déterminer si le second interrupteur principal (MS2) fonctionne mal sur la base d'une différence entre une variation de la seconde tension de batterie et une variation de la seconde tension de borne lors d'une transition du premier état au second état, ou du second état au premier état.

8. Procédé de fonctionnement d'un bloc-batterie (100) comprenant une batterie (110), un premier interrupteur principal (MS1) entre une première borne de bloc (T1) et une première borne de batterie (B1), un second interrupteur principal (MS2) entre une seconde borne de bloc (T2) et une seconde borne de batterie (B2), une première résistance (R1) et un premier interrupteur isolé (SW1) montés en série entre la première borne de batterie (B1) et une masse (GND), et une seconde résistance (R2) et un second interrupteur isolé (SW2) montés en série entre la seconde borne de batterie (B2) et la masse (GND), le procédé comprenant :
l'ouverture du premier interrupteur principal (MS1) ;
la commande du premier interrupteur isolé (SW1) et du second interrupteur isolé (SW2) pour répéter alternativement un premier état, dans lequel le premier interrupteur isolé (SW1) est fermé et le second interrupteur isolé (SW2) est ouvert, et un second état, dans lequel le premier interrupteur isolé (SW1) est ouvert et le second interrupteur isolé (SW2) est fermé ;
la détection d'une première tension de borne entre la première borne de bloc (T1) et la masse (GND) ; et
la détermination pour savoir si le premier interrupteur principal (MS1) fonctionne mal sur la base d'une différence entre la première tension de borne dans le premier état et la première tension de borne dans le second état.

9. Procédé selon la revendication 8, comprenant en outre :
l'ouverture du second interrupteur principal (MS2) ;
la détection d'une seconde tension de borne entre la seconde borne de bloc (T2) et la masse (GND) ; et
la détermination pour savoir si le second interrupteur principal (MS2) fonctionne mal sur la base d'une différence entre la seconde tension de borne dans le premier état et la seconde tension de borne dans le second état.

10. Procédé selon la revendication 8 ou la revendication 9, comprenant en outre :
la fermeture du premier interrupteur principal (MS1) ;
la commande du premier interrupteur isolé (SW1) et du second interrupteur isolé (SW2) pour répéter alternativement le premier état, dans lequel le premier interrupteur isolé (SW1) est fermé et le second interrupteur isolé (SW2) est ouvert, et le second état, dans lequel le premier interrupteur isolé (SW1) est ouvert et le second interrupteur isolé (SW2) est fermé ;
la détection d'une première tension de batterie entre la première borne de batterie (B1) et la masse (GND) ;
la détection de la première tension de borne entre la première borne de bloc (T1) et la masse (GND) ; et
la détermination pour savoir si le premier interrupteur principal (MS1) fonctionne mal sur la base d'une différence entre une variation de la première tension de batterie et une variation de la première tension de borne entre le premier état et le second état.

11. Procédé selon la revendication 10, comprenant en outre :
la fermeture du second interrupteur principal (MS2) ;
la détection d'une seconde tension de batterie entre la seconde borne de batterie (B2) et la masse (GND) ;
la détection d'une seconde tension de borne entre la seconde borne de bloc (T2) et la masse (GND) ; et
la détermination pour savoir si le second interrupteur principal (MS2) fonctionne mal sur la base d'une différence entre une variation de la seconde tension de batterie et une variation de la seconde tension de borne entre le premier état et le second état.
